# EUROPÄISCHE PATENTSCHRIFT

(11) **EP 0 446 320 B1**
(45) Veröffentlichungstag und Bekanntmachung des Hinweises auf die Patenterteilung: **22.06.1994**
(21) Anmeldenummer: 90913789.5
(22) Anmeldetag: 28.09.1990
(51) Int. Cl.: H05K 5/00

(54) **GEHÄUSE FÜR EINE ELEKTRONISCHE SCHALTUNG**
HOUSING FOR AN ELECTRONIC CIRCUIT
BOITIER POUR CIRCUIT ELECTRONIQUE

(30) Priorität: 04.10.1989 DE 3933084
(43) Veröffentlichungstag der Anmeldung: 18.09.1991
(73) Patentinhaber: ROBERT BOSCH GMBH, 70442 Stuttgart (DE)
(72) Erfinder: JAKOB, Gert, D-7000 Stuttgart 50 (DE); BENTZ, Willy, D-7123 Sachsenheim (DE); HUSSMANN, Dieter, D-7141 Steinheim (DE); SCHIEFER, Peter, D-7101 Abstatt (DE); KARR, Dieter, D-7533 Tiefenbronn (DE)
(86) Internationale Anmeldenummer: DE9000744
(87) Internationale Veröffentlichungsnummer: WO9105453

(56) Entgegenhaltungen:
- FR-A- 2 328 353
- FR-A- 2 483 730
- US-A- 4 471 407

## Beschreibung

### Stand der Technik

Die Erfindung betrifft ein Gehäuse für eine elektronische, mit Anschlußstecker versehene Schaltung, insbesondere für eine Steuergerätelektronik einer Brennkraftmaschine eines Fahrzeugs, mit einem Kühlrahmen, an dem eine die elektronische Schaltung aufweisende Leiterplatte befestigt ist und der mindestens einen Kühlabschnitt aufweist, mit dem an der Leiterplatte angeschlossene Leitungs-Bauelemente wärmeleitend verbunden sind, sowie mit einer die Leiterplatte umfangenden Abdeckung.

Ein derartiges Gehäuse ist aus der deutschen Patentschrift 25 46 334 bekannt. Das Gehäuse weist einen Kühlrahmen auf, der eine Platine trägt und Kammern zur Aufnahme von zu kühlenden Bauelementen -wie Lastwiderständen- aufweist. Der Kühlrahmen ist ferner zum Teil mit einem Boden versehen, auf dem sich relativ stark erwärmende Bauelemente einer Leistungsstufe befinden. Der Boden verläuft parallel zur Ebene der Leiterplatte, das heißt, er liegt rechtwinklig zu den Seitenwänden des Kühlrahmens. Am Kühlrahmen ist ein Aufnahmebügel lösbar befestigt, durch den ein Anschlußstecker ragt. Zur Abdeckung der Leiterplatte dient eine Haube, die über den die Leiterplatte aufweisenden Kühlrahmen gestülpt wird und mit ihrem Rand gegen einen Dichtring tritt, der in einer Führungsnut des Aufnahmebügels einliegt. Aufbau und Ausbildung des Gehäuses haben sich bewährt, sind jedoch recht kompliziert, da der Kühlrahmen ein Spezialprofil erfordert; es liegt daher eine kostenintensive Lösung vor. Überdies ist die Wärmeabführung der sich erwärmenden Bauelemente für bestimmte Ausgestaltungen verbesserungsbedürftig.

### Vorteile der Erfindung

Das erfindungsgemäße Gehäuse mit den im Hauptanspruch genannten Merkmalen hat demgegenüber den Vorteil, daß eine sehr einfache und damit kostengünstige Bauweise vorliegt, die eine sehr gute Wärmeableitung ermöglicht. Der Kühlrahmen ist erfindungsgemäß als Flachrahmen mit im wesentlichen parallel zur Ebene der Leiterplatte liegenden Flachrahmenschenkeln ausgebildet. Ein derartiger Flachrahmen ist sehr einfach herstellbar. Bevorzugt wird ein Blechstanzteil eingesetzt. An der Ober- und an der Unterseite des Flachrahmens sind eine Abdeckung für die Leiterplatte bildende Gehäusedeckel befestigt. Der die Leiterplatte tragende Flachrahmen wird somit beidseitig von jeweils einem Gehäusedeckel überfangen, wobei diese etwa wannenförmig ausgebildeten Gehäusedeckel ebenfalls auf einfache Weise herstellbar sind. Da der Flachrahmen großflächig mit den Gehäusedeckeln in Verbindung steht, ist eine gute Wärmeableitung gewährleistet.

Vorzugsweise gehen vom Flachrahmen in das Rahmeninnere weisende Haltezungen zur Befestigung der Leiterplatte aus. Die Haltezungen sind insbesondere derart gekröpft ausgebildet, daß die Leiterplatte in einer zu den Flachrahmenschenkeln parallel beabstandeten Ebene liegt. Hierdurch ist es möglich, trotz möglichst kleiner Grundfläche hinreichend Platz für eine -im nachstehenden noch näher beschriebene- Gehäuseabdichtung zu schaffen.

Nach einer Weiterbildung der Erfindung geht von mindestens einem der Flachrahmenschenkel wenigstens ein Kühlabschnitt aus, der als abgebogene Kühllasche ausgebildet ist. Die Kühllasche steht unter einem Winkel zur Ebene der Leiterplatte, der vorzugsweise 90° beträgt. Hierdurch ist es möglich, sich relativ stark erwärmende Bauelemente -insbesondere Leistungs-Bauelemente- schon bei der Erstellung der Leiterplatte auf dieser anzuordnen, wobei die Anschlußdrähte der Leistungs-Bauelemente mit den Leiterbahnen der Leiterplatte verlötet werden, und bei der Montage der Leiterplatte am Kühlrahmen eine wärmeabführende Verbindung zur Kühllasche herzustellen. Insbesondere gelangen die Gehäuse der Leistungs-Bauelemente großflächig in Anlage zur Kühllasche, so daß sich relativ kleine Wärmeübergangswiderstände ergeben.

Vorteilhaft ist es, wenn von den Flachrahmenschenkeln Dichtungsführungsleisten für eine dem einen der Gehäusedeckel zugeordneten, umlaufenden, ersten Dichtung abgebogen sind. Insbesondere sind die Dichtungsführungsleisten in die gleiche Richtung wie der jeweilige abgekröpfte Bereich der Haltezungen abgebogen. Die Dichtungsführungsleisten bilden Anschläge zur Fixierung der Dichtung.

Nach einem bevorzugten Ausführungsbeispiel der Erfindung gehen von dem anderen Gehäusedeckel Führungszungen aus, die rechtwinklig zur Ebene der Leiterplatte verlaufen, zwischen sich den Flachrahmen aufnehmen und diesen mit jeweils einem Abschnitt überragen. Die hervorstehenden Abschnitte bilden zusammen mit den Dichtungsführungsleisten einen Aufnahmekanal für die bereits erwähnte, erste Dichtung. Ferner stellen die Überragenden Abschnitte eine Führung für den einen Gehäusedeckel dar, so daß sich dieser bei der Montage mühelos selbst ausrichtet.

Insbesondere ist vorgesehen, daß der andere Gehäusedeckel eine Dichtungsaufnahmenut für eine umlaufende, gegen den Flachrahmen anliegende, zweite Dichtung aufweist. Mithin wird sowohl die Ober- als auch die Unterseite des Flachrahmens mit einer Dichtung beaufschlagt, gegen die die beiden Gehäusedeckel treten.

Für eine einfache Herstellung sind die beiden Gehäusedeckel als Tiefzieh-Blechteile ausgebildet.

Insbesondere kann vorgesehen sein, daß der Anschlußstecker an einem Tragsteg befestigt ist, der mit einander gegenüberliegenden Flachrahmenschenkeln in Verbindung steht. Der Flachrahmen übernimmt damit eine dritte Funktion; denn er ist nicht nur Träger der Leiterplatte und dient überdies nicht nur als Kühlrahmen, sondern übernimmt ferner eine zusätzliche Abstützung des mit der elektronischen Schaltung verbundenen Anschlußsteckers. Insbesondere stützt sich der Tragsteg auf den der Leiterplatte abgewandten Seiten entsprechend angeordneter Haltezungen ab. Gegen die einen Seiten dieser Haltezungen tritt somit die Leiterplatte und die anderen Seiten der Haltezungen werden von dem Tragsteg beaufschlagt.

Für eine einfache Befestigung und zur Abfuhr von Wärme sind die Eckbereiche des Flachrahmens von Befestigungsbohrungen durchsetzt, die mit entsprechenden Bohrungen in den beiden Gehäusedeckeln fluchten. Die die Befestigungsbohrungen durchgreifenden, der Montage des Gehäuses dienenden Befestigungsmittel können somit direkt die an den Flachrahmen bzw die Gehäusedeckel abgegebene Wärme an entsprechende Befestigungsbereiche -zum Beispiel die Karosserie oder das Chassis des Fahrzeugs- ableiten.

Vorzugsweise weist einer der Gehäusedeckel einen Durchbruch für den Anschlußstecker auf. Der direkt mit seinen Kontakten an der Leiterplatte angeschlossene Anschlußstecker ist somit aufgrund des Durchbruchs zum Aufstecken eines entsprechenden Buchsenteils von außen zugänglich. Im Randbereich des Durchbruchs ist vorzugsweise eine Dichtung angeordnet, so daß weder Schmutz noch Feuchtigkeit in das Innere des Gehäuses gelangen kann.

Die Leistungs-Bauelemente sind für eine thermische Verbesserung getrennt von der übrigen Elektronik der elektronischen Schaltung angeordnet.

Vorteilhafte Weiterbildungen der Erfindung sind in den Unteransprüchen gekennzeichnet.

### Zeichnung

Die Erfindung wird im folgenden anhand der Figuren näher erläutert. Es zeigen:
- Figur 1: eine Schnittansicht durch ein Gehäuse für eine elektronische Schaltung,
- Figur 2: eine Draufsicht auf einen Flachrahmen des Gehäuses,
- Figur 3: einen Querschnitt durch den Flachrahmen gemäß Figur 2,
- Figur 4: einen Längsschnitt durch ein weiteres Ausführungsbeispiel eines Gehäuses,
- Figur 5: einen Querschnitt durch das Gehäuse gemäß Figur 4,
- Figur 6: eine Draufsicht auf einen Flachrahmen des Ausführungsbeispiels gemäß Figur 4,
- Figur 7: ein weiteres Ausführungsbeispiel eines Gehäuses mit zwei Anschlußsteckern,
- Figur 8: ein Querschnitt durch das Gehäuse gemäß Figur 7 und
- Figur 9: eine Draufsicht auf einen Flachrahmen des Ausführungsbeispiels der Figur 7.

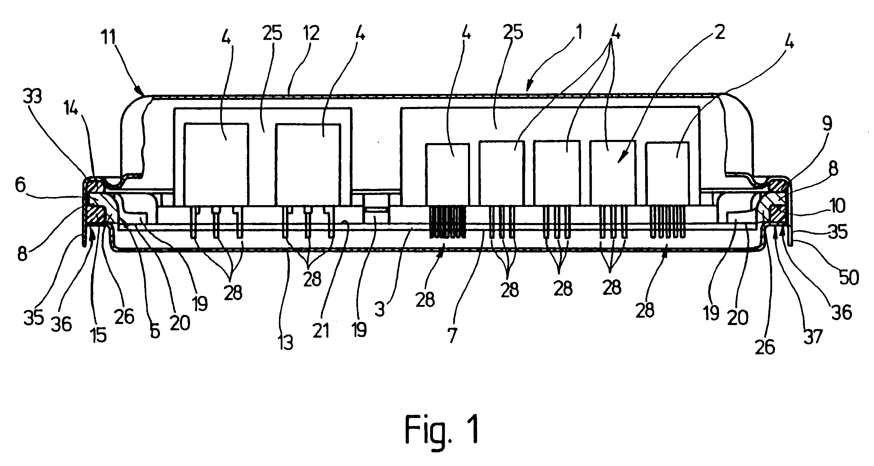

Die Figur 1 zeigt ein Gehäuse 1 für eine elektronische Schaltung 2, die auf einer Leiterplatte 3 angeordnet ist. Bei der elektronischen Schaltung 2 handelt es sich insbesondere um eine Steuergerätelektronik einer Brennkraftmaschine eines Fahrzeugs.

Die elektronische Schaltung 2 weist neben einer Vielzahl von -nicht dargestellten- Bauteilen Leistungs-Bauelemente 4 auf, die beispielsweise als Leistungstransistoren ausgebildet sein können.

Das Gehäuse 1 weist einen Kühlrahmen 5 auf, der als Flachrahmen 6 ausgebildet ist und im wesentlichen parallel zur Ebene 7 der Leiterplatte 3 liegende Flachrahmenschenkel 8 besitzt. Der Flachrahmen 6 hat einen rechteckigen Grundriß.

An der Oberseite 9 sowie Unterseite 10 des Flachrahmens 6 sind die Leiterplatte 3 umfangende, eine Abdeckung 11 bildende Gehäusedeckel 12 und 13 unter Zwischenschaltung von umlaufenden Dichtungen 14 und 15 angeordnet.

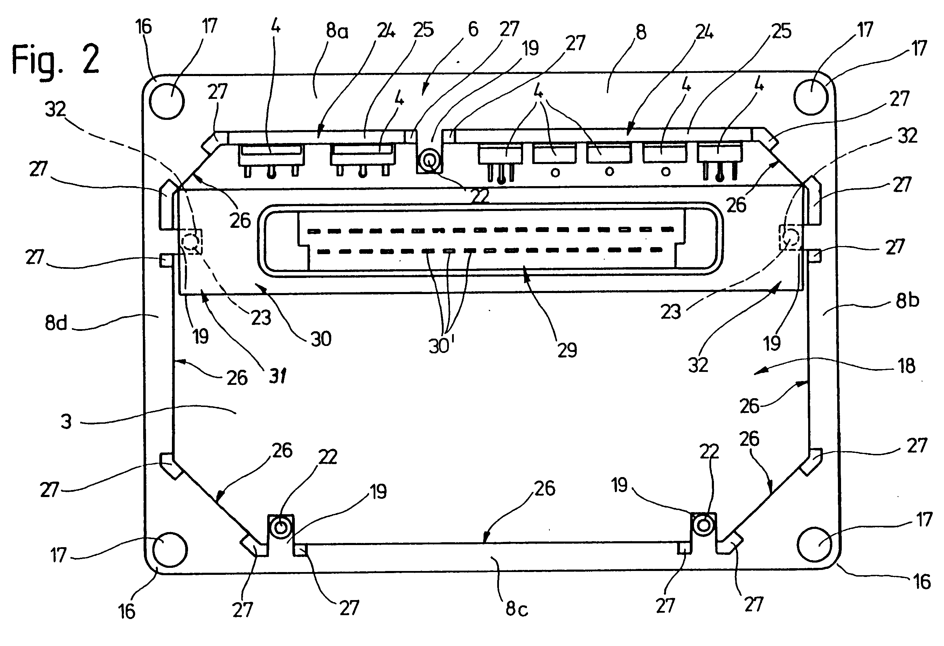

Im Nachfolgenden soll zunächst auf die Ausbildung des Flachrahmens 6 eingegangen werden. Die Figur 2 zeigt, daß der Flachrahmen 6 insgesamt vier Flachrahmenschankel 8 aufweist, die -zum besseren Verständnis- mit 8a, 8b, 8c und 8d bezeichnet sind. In den Eckbereichen 16 des Flachrahmens 6 sind Befestigungsbohrungen 17 ausgebildet. Der Flachrahmen 6 ist als Blechstanzteil ausgebildet, das heißt, er wird aus einem Blech ausgestanzt und dabei bzw anschließend noch einem oder mehreren Biegevorgängen unterworfen. Auf letzteres wird im nachfolgenden noch näher eingegangen.

Vom Flachrahmen 6 gehen in das Rahmeninnere 18 weisende Haltezungen 19 aus, die der Befestigung der Leiterplatte 3 dienen. Die Haltezungen 19 sind abgekröpft, das heißt, sie sind -gemäß Figur 1- vom jeweiligen Rahmenschenkel 8 ausgehend zunächst nach unten abgebogen und knicken dann in entgegengesetzter Richtung ab, so daß ihre Unterseiten 20 parallel zur Ebene der Flachrahmenschenkel 8 verläuft. Die Leiterplatte 3 liegt mit ihrer Oberseite 21 gegen die Unterseiten 20 der Haltezungen 19 an und wird mittels geeigneter Befestigungsmittel (zum Beispiel Schrauben) dort fixiert. Einige der Haltezungen 19 weisen hierzu Gewindebohrungen 22 auf; andere sind mit Durchgangsbohrungen 23 versehen.

Von dem Flachrahmenschenkel 8a gehen zwei Kühlabschnitte 24 aus, die als - entgegengesetzt zu den Haltezungen 19 abgebogene Kühllaschen 25 ausgebildet sind. Die Kühllaschen 25 verlaufen rechtwinklig zur Ebene 7 der Leiterplatte 3.

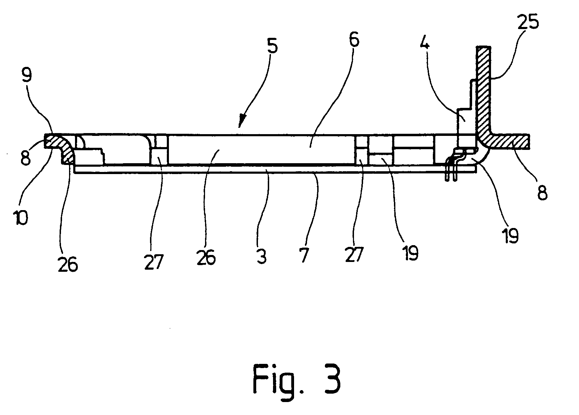

Die Flachrahmenschenkel 8b, 8c und 8d sowie sämtliche Eckbereiche 16 sind mit Dichtungsführungsleisten 26 versehen. Diese sind insbesondere aus den Figuren 1 und 3 ersichtlich. Sie werden von entgegengesetzt zu den Kühllaschen 25 abgebogenen Bereichen des inneren Randes des Flachrahmens 6 gebildet. Die Dichtungsführungsleisten 26 werden jeweils durch beidseitige Freischnitte 27 seitlich begrenzt. Dieses gilt auch für die Kühllaschen 25.

Die Anordnung ist derart ausgebildet, daß die mittels ihrer Anschlußdrähte 28 mit den Leiterbahnen der Leiterplatte 3 verbundenen Leistungs-Bauelemente eine derartige Hochkant-Lage einnehmen, daß sie mit ihren der Wärmeableitung dienenden Rückseiten flächig an den Kühllaschen 25 anliegen. Durch geeignete Metallfederklemmen, die sich einseitig an den Außenseiten der Kühllaschen 25 und anderseitig an den Leistungs-Bauelementen abstützen, können -zur Minimierung des Wärmeübergangswiderstandes- die Leistungs-Bauelemente fest gegen die Kühllaschen 25 gepreßt werden (in den Figuren 1 bis 3 nicht dargestellt).

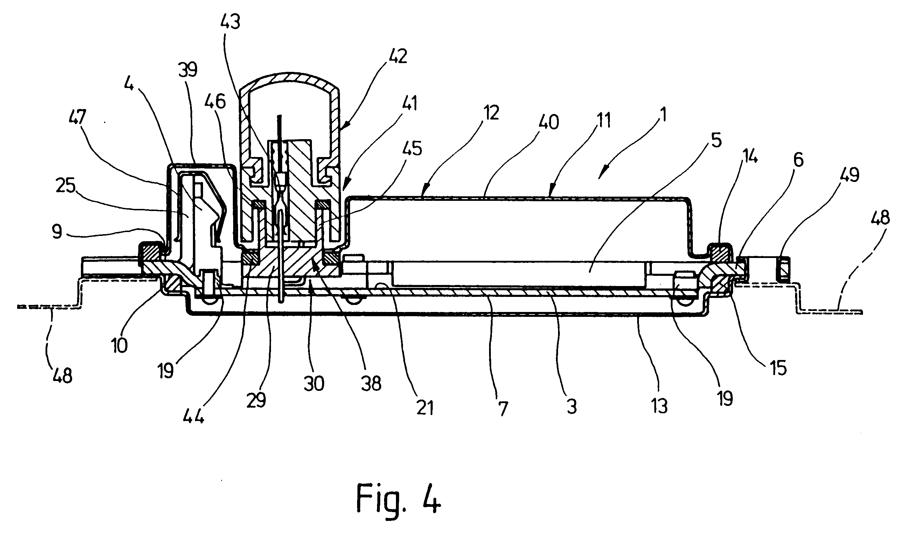

Aus der Figur 1 geht hervor, daß die beiden Gehäusedeckel 12 und 13 wannenförmig ausgebildet sind. Der Gehäusedeckel 12 weist haubenförmige Auswölbungen auf, die beidseitig eines die Gehäusedeckelwandung durchsetzenden Anschlußsteckers 29 ausgebildet sind. Sie dienen der Aufnahme der hochkant stehenden Leistungs-Bauelemente und ferner der übrigen, nicht dargestellten, auf der Oberseite 21 der Leiterplatte 3 befindlichen Bauelemente (diese Ausbildung geht insbesondere aus dem weiteren Ausführungsbeispiel der Figur 4 hervor, auf das im nachfolgenden noch näher eingegangen wird).

Der Anschlußstecker 29 ist mit seinen Kontakten 30' direkt mit den Leiterbahnen der Leiterplatte 3 verlötet. Er durchsetzt eine Öffnung eines Tragstegs 30, der sich mit seinen Endbereichen 31 und 32 auf den der Leiterplatte 3 abgewandten Seiten 32 der von den Flachrahmenschenkeln 8b und 8d ausgehenden Haltezungen 19 abstützt. Mittels Halteschrauben, deren Köpfe an der Unterseite der Leiterplatte 3 anliegt und deren Gewindeschäfte sowohl entsprechende Bohrungen der Leiterplatte als auch die Durchgangsbohrungen 23 der Haltezungen 19 durchsetzen, ist die Befestigung des Tragstegs 30 vorgenommen, indem die Gewindeschäfte dieser Schrauben in entsprechende Gewindebohrungen des Tragstegs 30 eingeschraubt sind. Der Tragsteg 30 selbst steht wiederum über mehrere Schraubverbindungen mit dem Gehäuse des Anschlußsteckers 29 in Verbindung. Vorzugsweise sind die genannten Gewindebohrungen des Tragstegs 30 in an seiner Unterseite ausgebildeten, vorstehenden Böckchen angeordnet, die auf den entsprechenden Haltezungen 19 aufliegen.

Aus der Figur 1 geht hervor, daß der Gehäusedeckel 12 der -ebenso wie der Gehäusedeckel 13 als Tiefzieh-Blechteil ausgebildet ist, eine geprägte, im wesentlichen umlaufende Dichtungsaufnahmenut 33 aufweist. Diese nimmt die Dichtung 14 auf, die sich auf der Oberseite 9 des Flachrahmens 6 abstützt. Der Seitenrand 34 des Gehäusedeckels 12, der rechtwinklig zur Ebene 7 der Leiterplatte 3 verläuft, weist -außerhalb der Eckbereiche- Führungszungen 35 auf, die die Stirnenden 36 des Gehäusedeckels 13 überlappen. Mit Abschnitten 50 steht der Seitenrand 34 über den Flachrahmen vor.

Zwischen den Außenseiten der Dichtungsführungsleisten 26 und den Innenseiten der Führungszungen 35 ist ein Aufnahmekanal 37 für die Dichtung 15 ausgebildet, die einerseits gegen die Unterseite 10 des Flachrahmens 6 und andererseits gegen den abgekröpften Randbereich des Gehäusedeckels 13 anliegt.

In den Eckbereichen der Gehäusedeckel 12 und 13 sind Bohrungen ausgebildet, die mit den Befestigungsbohrungen 17 des Flachrahmens 6 fluchten. Mittels geeigneter Befestigungselemente können somit Gehäusedeckel 12, Flachrahmen 6 und Gehäusedeckel 13 miteinander unter Pressung der Dichtungen 14 und 15 verspannt werden. Als Befestigungsmittel können beispielsweise Hohlnieten verwendet werden, die wiederum von geeigneten Befestigungselementen durchsetzt werden, um das Gehäuse am Chassis oder an der Karosserie eines Kraftfahrzeugs zu befestigen.

Um eine staub- und wasserdichte Ausführung zu erhalten, erfolgt ferner eine Abdichtung des Durchbruches des Gehäusedeckels 12, der von dem Anschlußstecker 29 durchsetzt wird.

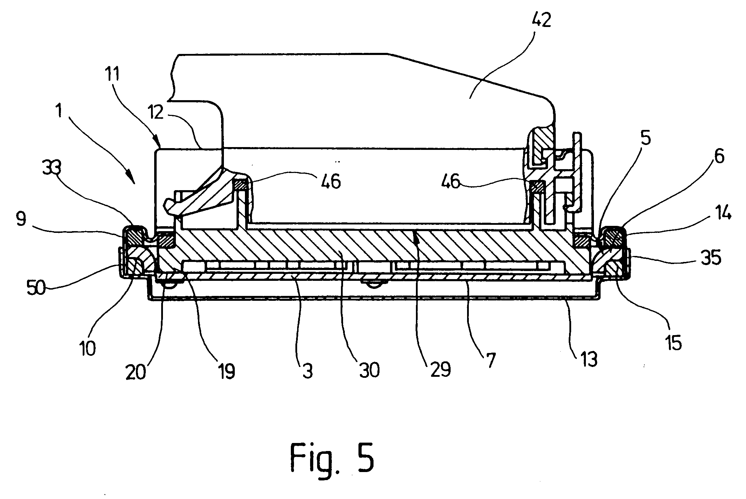

Die Figuren 4 bis 6 zeigen ein weiteres Ausführungsbeispiel eines erfindungsgemäßen Gehäuses, wobei gleiche Teile mit gleichen Bezugszeichen versehen sind. Aus der Figur 4 gehen deutlich die beiden haubenförmigen Auswölbungen 39 und 40 des Gehäusedeckels 12 hervor. Ferner ist ein zwischen den Auswölbungen 39 und 40 tiefer liegender Bereich 41 erkennbar, der den Durchbruch 38 für den Anschlußstecker 29 aufweist. Ferner ist ein Buchsenteil 42 dargestellt, das mit dem Anschlußstecker 29 verbindbar ist und mit den Kontakten 30' zusammenwirkende Gegenkontakte 43 aufweist. Schließlich ist die zwischen dem Anschlußstecker 29 und dem Gehäusedeckel 12 angeordnete Dichtung 44 erkennbar. Eine weitere Abdichtung erfolgt dadurch, daß eine umlaufende Stegwandung 45 des Anschlußsteckers 29 mit einer Dichtung 46 des Buchsenteils 42 zusammenwirkt.

Aus der Figur 4 gehen ferner die zuvor erwähnten Metallfederklemmen 47 hervor, mit der die Leistungs-Bauelemente 4 gegen die Kühllaschen 25 gepreßt werden. Ferner sind dort bei bestimmten Verhältnissen einsetzbare Befestigungswinkel 48 mit gestrichelter Linie eingetragen, die der Befestigung des Gehäuses an einem gewünschten Ort dienen. Überdies ist ein Hohlniet 49 dargestellt, der die entsprechenden Befestigungsbohrungen 17 sowie die zugehörigen Bohrungen der Gehäusedeckel 12 und 13 durchgreift.

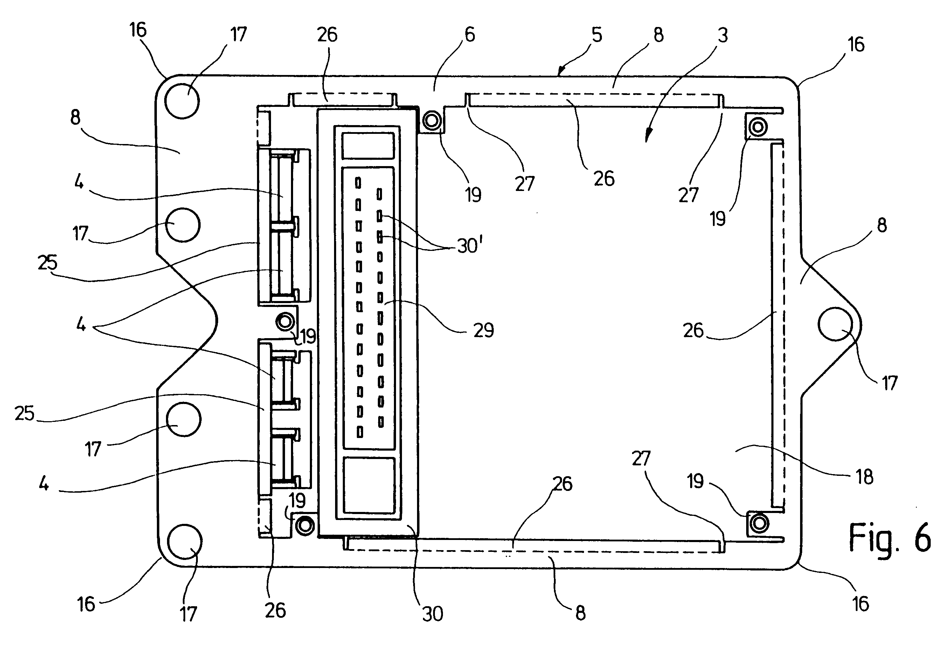

Die Figur 6 Zeigt, daß der dort dargestellte Tragrahmen 6 gegenüber dem Ausführungsbeispiel der Figur 2 in der Form seines Grundrisses abweicht. Der sonstige Aufbau entspricht jedoch grundsätzlich dem des zuvor beschriebenen Ausführungsbeispiels, so daß sich weitere Ausführungen erübrigen.

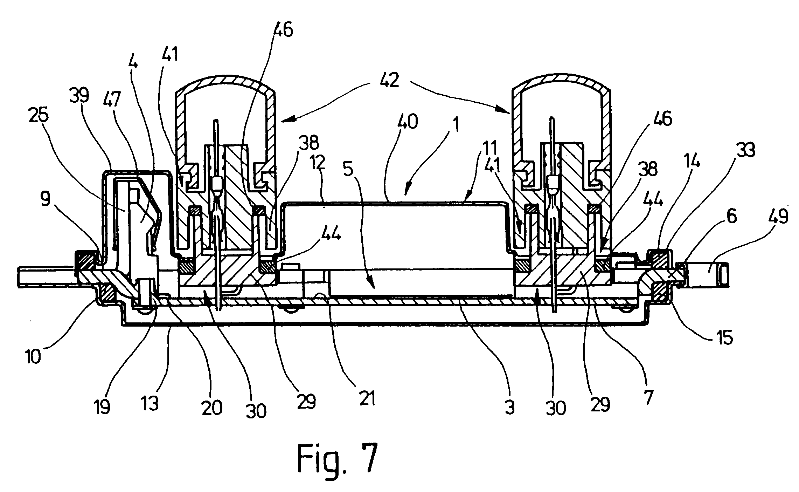

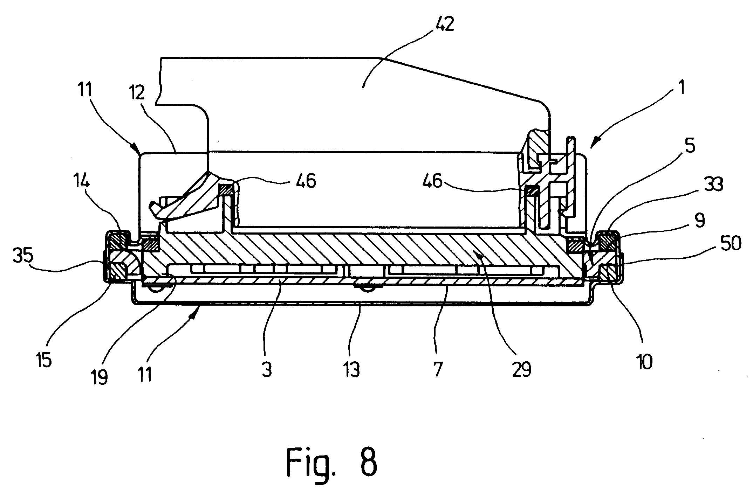

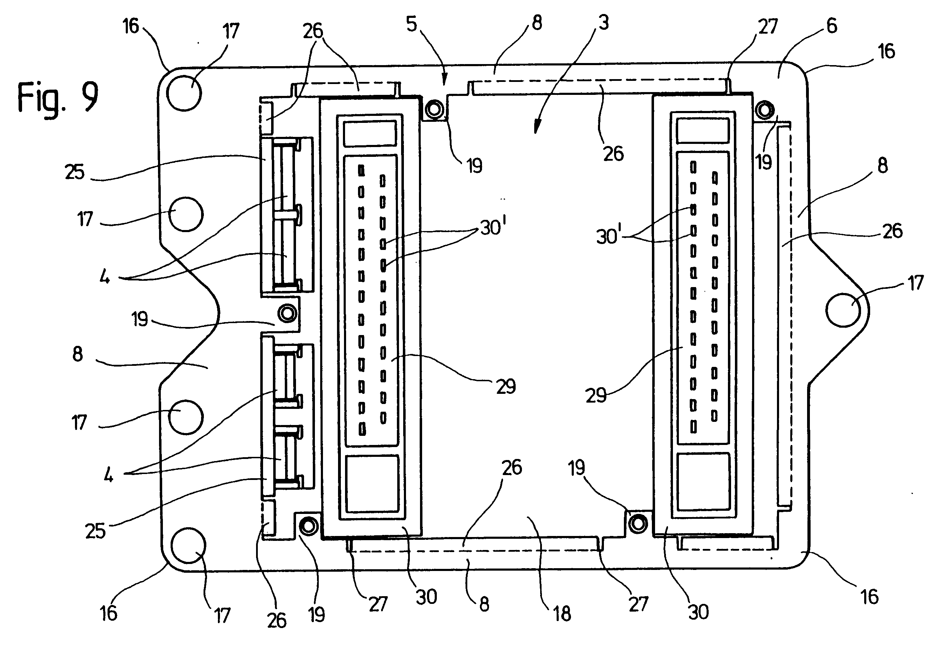

Ein weiteres Ausführungsbeispiel der Erfindung ist in den Figuren 7 bis 9 dargestellt, das dem zuvor beschriebenen Ausführungsbeispiel entspricht, jedoch zwei Anschlußstecker 29 mit entsprechend zugehörigen Buchsenteilen 42 zeigt.

Durch den erfindungsgemäßen Aufbau dient der Flachrahmen 6 der beschriebenen Ausführungsbeispiele als Träger für die Leiterplatte 3, den bzw. die Anschlußstecker 29, die Dichtungen 14 und 15 sowie als Wärmeableitelement für die Verlustwärme der Leistungs-Bauelemente 4. Aufgrund des erfindungsgemäßen Aufbaus treten keine mechanischen Belastungen an den Lötstellen der elektronischen Schaltung auf. Durch die Ausführung des Flachrahmens 6 mit Kühllaschen 25 sowie die entsprechende Verbindung mit den Gehäusedeckeln 12 und 13 ergibt sich eine gute Wärmeableitung der Leistungs-Bauelemente 4. Aufgrund der beschriebenen Dichtungen läßt sich eine staub- und feuchtigkeitsdichte Ausführung auf einfache Weise erzielen. Wird das Steuergerät im Fahrzeuginnenraum montiert, so können die Dichtungen entfallen. Insbesondere ist die Anordnung des Anschlußsteckers 29 derart gewählt, daß auf einer Seite von ihm die Leistungsbauteile und auf der anderen Seite die restliche Elektronik liegt. Hierdurch ergeben sich Vorteile durch verringerte Störeinflüsse der Leistungs-Bauelemente 4 auf die restliche Elektronik, die Wärmebeeinflußung der Leistungs-Bauelemente auf die übrige Elektronik wird verringert und es vereinfacht sich die Leitungsführung auf der Leiterplatte 3. Die Befestigung des erfindungsgemäßen Gehäuses 1 an der Karosserie oder dem Chassis eines Fahrzeugs führt dazu, daß ein direkter Wärmeabfluß erfolgen kann. Gegebenenfalls wird die Befestigung mit zusätzlichen anbauspezifischen Elementen (zum Beispiel Befestigungswinkeln 41) vorgenommen.

## Patentansprüche

1. Gehäuse (1) für eine elektronische, mit Anschlußstecker versehene Schaltung, insbesondere für eine Steuergerätelektronik einer Brennkraftmaschine eines Fahrzeugs, mit einem Kühlrahmen (5), an dem eine die elektronische Schaltung aufweisende Leiterplatte (3) befestigt ist und der mindestens einen Kühlabschnitt (24) aufweist, mit dem an der Leiterplatte angeschlossene Leistungs-Bauelemente wärmeleitend verbunden sind, sowie mit einer die Leiterplatte umfangenden Abdeckung (11), **dadurch gekennzeichnet**, daß der Kühlrahmen (5) als Flachrahmen (6) mit im wesentlichen parallel zur Ebene (7) der Leiterplatte (3) liegenden Flachrahmenschenkeln (8, 8a, 8b, 8c, 8d) ausgebildet ist, an dessen Ober- und Unterseite (9, 10) die Abdeckung (11) bildende Gehäusedeckel (12, 13) angeordnet sind.

2. Gehäuse nach Anspruch 1**, dadurch gekennzeichnet**, daß der Flachrahmen (6) als Blechstanzteil ausgebildet ist.

3. Gehäuse nach einem der vorhergehenden Ansprüche, **dadurch gekennzeichnet**, daß vom Flachrahmen (6) in das Rahmeninnere (18) weisende Haltezungen (19) zur Befestigung der Leiterplatte (3) ausgehen.

4. Gehäuse nach Anspruch 3, **dadurch gekennzeichnet**, daß die Haltezungen (19) derart gekröpft ausgebildet sind, daß die Leiterplatte (3) in einer zu den Flachrahmenschenkeln (8, 8a, 8b, 8c, 8d) parallel beabstandeten Ebene liegt.

5. Gehäuse nach einem der vorhergehenden Ansprüche, **dadurch gekennzeichnet**, daß von mindestens einem der Flachrahmenschenkel (8, 8a, 8b, 8c, 8d) wenigstens ein Kühlabschnitt (24) ausgeht, der als abgebogene Kühllasche (25) ausgebildet ist.

6. Gehäuse nach Anspruch 5, **dadurch gekennzeichnet**, daß die Kühllasche (25) im wesentlichen rechtwinklig zur Ebene (7) der Leiterplatte (3) verläuft.

7. Gehäuse nach einem der vorhergehenden Ansprüche, **dadurch gekennzeichnet**, daß von den Flachrahmenschenkeln (8, 8a, 8b, 8c, 8d) Dichtungsführungsleisten (26) für die Ausrichtung einer dem einen der Gehäusedeckel (13) zugeordneten, umlaufenden, ersten Dichtung (15) abgebogen sind.

8. Gehäuse nach Anspruch 7, **dadurch gekennzeichnet**, daß die Dichtungsführungsleisten (26) in die gleiche Richtung wie der jeweilige abgekröpfte Bereich der Haltezungen (19) abgebogen sind.

9. Gehäuse nach Anspruch 8 oder 7, **dadurch gekennzeichnet**, daß von dem anderen Gehäusedeckel (12) Führungszungen (35) ausgehen, die rechtwinklig zur Ebene (7) der Leiterplatte (3) verlaufen, zwischen sich den Flachrahmen (6) aufnehmen und diesen mit jeweils einem Abschnitt (50) überragen.

10. Gehäuse nach Anspruch 9, 8 oder 7, **dadurch gekennzeichnet**, daß der andere Gehäusedeckel (12) eine Dichtungsaufnahmenut (33) für eine umlaufende, gegen den Flachrahmen (6) anliegende, zweite Dichtung (14) aufweist.

11. Gehäuse nach einem der vorhergehenden Ansprüche, **dadurch gekennzeichnet**, daß die beiden Gehäusedeckel (12, 13) als Tiefzieh-Blechteile ausgebildet sind.

12. Gehäuse nach einem der vorhergehenden Ansprüche, **dadurch gekennzeichnet**, daß der Anschlußstecker (29) an einem Tragsteg (30) befestigt ist, der mit einander gegenüberliegenden Flachrahmenschenkeln (8b, 8d) in Verbindung steht.

13. Gehäuse nach Anspruch 12, **dadurch gekennzeichnet**, daß sich der Tragsteg (30) auf den der Leiterplatte (3) abgewandten Seiten (32) entsprechend angeordneter Haltezungen (19) abstützt.

14. Gehäuse nach einem der vorhergehenden Ansprüche, **dadurch gekennzeichnet**, daß die Eckbereiche (16) des Flachrahmens (6) von Befestigungsbohrungen (17) durchsetzt sind, die mit entsprechenden Bohrungen in den beiden Gehäusedeckeln (12, 13) fluchten.

15. Gehäuse nach einem der vorhergehenden Ansprüche, **dadurch gekennzeichnet**, daß einer der Gehäusedeckel (12) einen Durchbruch (38) für den Anschlußstecker (29) aufweist.

16. Gehäuse nach einem der vorhergehenden Ansprüche, **dadurch gekennzeichnet**, daß die Leistungs-Bauelemente (4) getrennt von der übrigen Elektronik angeordnet sind.

## Claims

1. Housing (1) for an electronic circuit provided with connector plug, particularly for controller electronics of in internal combustion engine of a vehicle, comprising a cooling frame (5) on which a circuit board (3) exhibiting the electronic circuit is mounted and which exhibits at least one cooling section (24) to which power components connected on the circuit board are thermally conductively connected, and comprising a cover (11) enclosing the circuit board, characterized in that the cooling frame (5) is constructed as flat frame (6) having flat frame legs (8, 8a, 8b, 8c, 8d) located essentially in parallel with the plane (7) of the circuit board (3), at the tap and underside (9, 10) of which legs housing covers (12, 13) forming the cover (11) are arranged.

2. Housing according to Claim 1, characterized in that the flat frame (6) is constructed as stamped sheet-metal part.

3. Housing according to one of the preceding claims, characterized in that holding tongues (19) pointing into the interior (18) of the frame for mounting the circuit board (3) project from the flat frame (6).

4. Housing according to Claim 3, characterized in that the holding tongues (19) are constructed offset in such a manner that the circuit board (3) is located in a plane spaced apart in parallel from the flat frame legs (8, 8a, 8b, 8c, 8d).

5. Housing according to one of the preceding claims, characterized in that at least one cooling section (24) which is constructed as bent-away cooling lug (25) projects from at least one of the flat frame legs (8, 8a, 8b, 8c, 8d).

6. Housing according to Claim 5, characterized in that the cooling lug (25) extends essentially at right angles to the plane (7) of the circuit board (3).

7. Housing according to one of the preceding claims, characterized in that sealing guide strips (26) for aligning a first peripheral seal (15) allocated to one of the housing covers (13) are bent away from the flat frame legs (8, 8a, 8b, 8c, 8d).

8. Housing according to Claim 7, characterized in that the sealing guide strips (26) are bent away in the same direction as the respective offset area of the holding tongues (19).

9. Housing according to Claim 8 or 7, characterized in that guide tongues (35), which extend at right angles to the plane (7) of the circuit board (3), accommodate between themselves the flat frame (6) and protrude over the latter with in each case one section (50), project from the other housing cover (12).

10. Housing according to Claim 9, 8 or 7, characterized in that the other housing cover (12) exhibits a seal-receiving groove (33) for a second peripheral seal (14) resting against the flat frame (6).

11. Housing according to one of the preceding claims, characterized in that the two housing covers (12, 13) are constructed as deep-drawn sheet-metal parts.

12. Housing according to one of the preceding claims, characterized in that the connector plug (29) is mounted on a support web (30) which is connected to mutually opposite flat frame legs (8b, 8d).

13. Housing according to Claim 12, characterized in that the support web (30) is supported on the sides (32), facing away from the circuit board (3), of correspondingly arranged holding tongues (19).

14. Housing according to one of the preceding claims, characterized in that mounting holes (17), which are aligned with corresponding holes in the two housing covers (12, 13), pass through the corner areas (16) of the flat frame (6).

15. Housing according to one of the preceding claims, characterized in that one of the housing covers (12) exhibits an opening (38) for the connector plug (29).

16. Housing according to one of the preceding claims, characterized in that the power components (4) are arranged separately from the remaining electronics.

## Revendications

1. Boîtier (1) pour un circuit électronique pourvu de fiches de raccordement, en particulier pour une électronique d'appareils de commande d'un moteur à combustion interne, avec un cadre de refroidissement (5), sur lequel est fixé une carte de circuit imprimé (3) portant le circuit électronique et qui présente au moins une section de refroidissement (24), à laquelle sont reliés des composants de puissance raccordés à la carte de circuit imprimé d'une manière qui conduit la chaleur, ainsi qu'avec un couvercle (11) entourant la carte de circuit imprimé, caractérisé en ce que le cadre de refroidissement (5) est constitué sous la forme d'un cadre plat (6) avec des branches (8, 8a, 8b, 8c, 8d) se trouvant sensiblement parallèles au plan (7) de la carte de circuit imprimé (3), branches sur la face supérieure et la face inférieure (9, 10) desquelles sont disposés les couvercles de boîtier (12, 13) formant le recouvrement (11).

2. Boîtier selon la revendication 1, caractérisé en ce que le cadre plat (6) est constitué sous la forme d'une pièce de tôle estampée.

3. Boîtier selon l'une des revendications précédentes, caractérisé en ce que des languettes de fixation (19) orientées vers l'intérieur du cadre (18) sortent du cadre plat (6) pour fixer la carte de circuit imprimé (3).

4. Boîtier selon la revendication 3, caractérisé en ce que les languettes de fixation (19) sont constituées en étant coudées de telle façon que la carte de circuit imprimé (3) soit dans un plan situé à une certaine distance des branches (8, 8a, 8b, 8c, 8d) du cadre plat et parallèlement à celles-ci.

5. Boîtier selon l'une des revendications précédentes, caractérisé en ce qu'au moins une section de refroidissement (24) qui est constituée sous la forme d'une aile de refroidissement (25) coudée, part d'au moins l'une des branches du cadre plat (8, 8a, 8b, 8c, 8d).

6. Boîtier selon la revendication 5, caractérisé en ce que l'aile de refroidissement (25) s'étend sensiblement à angle droit par rapport au plan (7) de la carte de circuit imprimé (3).

7. Boîtier selon l'une des revendications précédentes, caractérisé en ce que l'on coude à partir des branches du cadre plat (8, 8a, 8b, 8c, 8d) des barreaux de guidage du joint d'étanchéité (26) pour la mise en place d'un premier joint d'étanchéité (15), qui fait tout le tour, associé à l'un des couvercles du boîtier, le couvercle (13).

8. Boîtier selon la revendication 7, caractérisé en ce que les barreaux de guidage du joint d'étanchéité (26) sont coudés dans le même sens que la zone coudée correspondante des languettes de fixation (19).

9. Boîtier selon la revendication 7 ou 8, caractérisé en ce que des languettes de guidage (35) partent de l'autre couvercle de boîtier (12), languettes qui s'étendent à angle droit par rapport au plan (7) de la carte de circuit imprimé (3), qui reçoivent entre elles le cadre plat (6) et surplombent celui-ci par respectivement une section (50).

10. Boîtier selon les revendications 7, 8 ou 9, caractérisé en ce que l'autre couvercle de boîtier (12) présente une rainure (33) servant à recevoir une deuxième garniture d'étanchéité (14), faisant tout le tour, et reposant contre le cadre plat (6).

11. Boîtier selon l'une des revendications précédentes, caractérisé en ce que les deux couvercles de boîtier (12, 13) sont constitués sous la forme de pièces de tôle formées par emboutissage profond.

12. Boîtier selon l'une des revendications précédentes, caractérisé en ce que la fiche de raccordement (29) est fixée à une barrette de support (30) qui est en liaison avec les branches (8b, 8d) du cadre plat opposé l'une à l'autre.

13. Boîtier selon la revendication 12, caractérisé en ce que la barrette support (30) s'appuie sur les faces (32) situées à l'opposé de la carte de circuit imprimé (3) correspondant aux languettes de fixation associées (19).

14. Boîtier selon l'une des revendications précédentes, caractérisé en ce que les coins (16) du cadre plat (6) sont traversés par des perçages de fixation (17), qui viennent en alignement avec des perçages correspondants dans les deux couvercles de boîtier (12, 13).

15. Boîtier selon l'une des revendications précédentes, caractérisé en ce que l'un des couvercles de boîtier (12) présente une interruption (38) pour la fiche de raccordement (29).

16. Boîtier selon l'une des revendications précédentes, caractérisé en ce que les composants de puissance (4) sont disposés séparément des autres composants électroniques.
